# EUROPEAN PATENT APPLICATION

(11) **EP 4 607 592 A1**
(43) Date of publication of application: **27.08.2025**
(21) Application number: 23880211.0
(22) Date of filing: 18.10.2023
(51) Int. Cl.: H01L 25/075, H01L 27/15, H01L 33/54, H01L 33/44

(54) **LIGHT-EMITTING DEVICE AND DISPLAY DEVICE COMPRISING SAME**

(30) Priority: 20.10.2022 US 202263417696 P; 16.10.2023 US 202318487427
(71) Applicant: Seoul Viosys Co., Ltd., Ansan-si, Gyeonggi-do 15429 (KR)
(72) Inventor: PARK, Jae Hyun, Ansan-si Gyeonggi-do 15429 (KR); HONG, Seung Sik, Ansan-si Gyeonggi-do 15429 (KR); HWANG, Jung Hwan, Ansan-si Gyeonggi-do 15429 (KR); KI, Young Sik, Ansan-si Gyeonggi-do 15429 (KR)
(74) Representative: Stolmár & Partner Patentanwälte PartG mbB
(86) International application number: PCT/KR2023/016108
(87) International publication number: WO 2024/085634

(57) **Abstract**

A light emitting apparatus and a display apparatus including the same are disclosed. The light emitting apparatus is a light emitting apparatus (10) including at least two light emitting modules (100) disposed adjacent each other. The light emitting module (100) includes a substrate (110), at least one light emitting device (120) disposed on an upper surface of the substrate (110), and a molding layer (130) covering at least part of the light emitting device (120).

## Description

### [Technical Field]

The present invention relates to a light emitting apparatus and a display apparatus including the same, and more particularly to a light emitting apparatus that includes at least two light emitting modules disposed adjacent each other, and a display apparatus including the same.

### [Background Art]

In general, a display apparatus realizes a variety of colors using a mixture of blue, green, and red colors. The display apparatus may include a plurality of pixels to realize various images, in which each pixel is provided with blue, green, and red subpixels.

A color of a particular pixel is determined through combination of colors of these subpixels and an image is realized through combination of these pixels. A display apparatus may be completed by connecting light emitting modules each including a PCB having a number of pixels thereon to each other.

However, a typical light emitting apparatus suffers from a problem of light interference at side surfaces of adjacent light emitting modules joined to each other, causing generation of bright lines at a boundary between the adjacent light-emitting modules, or a problem of decrease in brightness at the boundary therebetween, causing generation of dark black lines displayed on a screen.

### [Disclosure]

### [Technical Problem]

It is an aspect of the present invention to provide a light emitting apparatus that can prevent a bright line or a dark line from being displayed at a seam between light emitting modules disposed adjacent each other, and a display apparatus including the same.

### [Technical Solution]

In accordance with one aspect of the present invention, a light emitting apparatus (10) includes at least two light emitting modules (100) disposed adjacent each other.

In one embodiment, each of the light emitting modules (100) may include a substrate (110), at least one light emitting device (120) disposed on an upper surface of the substrate (110), and a molding layer (130) covering at least part of the light emitting device (120).

In one embodiment, at least one side surface of one of the two adjacent light emitting modules (100) may be spaced apart from an opposite side surface of the other light emitting module (100) to form a separation zone (R) therebetween in at least some regions thereof.

In one embodiment, at least some regions of the opposite side surfaces of the adjacent light emitting modules (100) may form inclined planes (U).

In one embodiment, the light emitting module (100) may include at least a variable width zone V in which a horizontal width of the light emitting module (100) varies from top to bottom of the light emitting module (100).

### [Advantageous Effects]

Embodiments of the present invention may provide a light emitting apparatus, which can prevent a bright line or a dark line from being displayed at a seam between light emitting modules disposed adjacent each other, and a display apparatus including the same.

### [Description of Drawings]

FIG. 1 is a plan view of a display apparatus according to one embodiment of the present invention.
FIG. 2 is a plan view of a light emitting module constituting the display apparatus of FIG. 1.

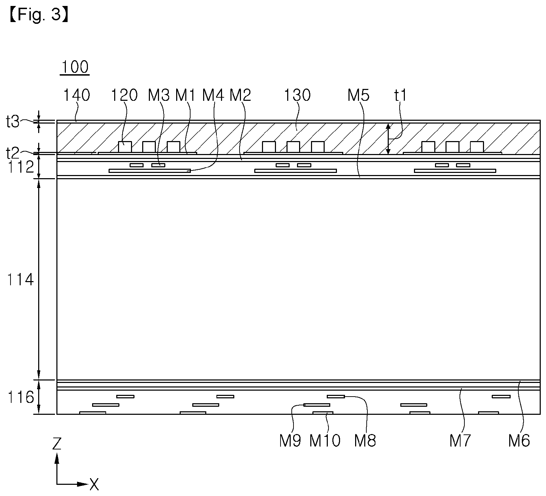

FIG. 3 is a cross-sectional view taken along line A-A of FIG. 2.
FIG. 4 is a cross-sectional view showing a boundary between two adjacent light emitting modules in one embodiment of the present invention.
FIG. 5A is a cross-sectional view showing a boundary between two adjacent light emitting modules in another embodiment of the present invention.
FIG. 5B and FIG. 5C are cross-sectional views of modifications of FIG. 5A.
FIG. 6A is a cross-sectional view showing a boundary between two adjacent light emitting modules in a further embodiment of the present invention.
FIG. 6B is a cross-sectional view of a modification of FIG. 6A.
FIG. 7A is a cross-sectional view showing a boundary between two adjacent light emitting modules in yet another embodiment of the present invention.
FIG. 7B is a cross-sectional view of a modification of FIG. 7A.
FIG. 8A is a cross-sectional view showing a boundary between two adjacent light emitting modules in yet another embodiment of the present invention.
FIG. 8B and FIG. 8C are cross-sectional views of modifications of FIG. 8A.
FIG. 9A is a cross-sectional view showing a boundary between two adjacent light emitting modules in yet another embodiment of the present invention.
FIG. 9B is a cross-sectional view of a modification of FIG. 9A.
FIG. 10A is a cross-sectional view showing a boundary between two adjacent light emitting modules in yet another embodiment of the present invention.
FIG. 10B to FIG. 10D are cross-sectional views of modifications of FIG. 10A.
FIG. 11A is a cross-sectional view showing a boundary between two adjacent light emitting modules in yet another embodiment of the present invention.
FIG. 11B to FIG. 11C are cross-sectional views of modifications of FIG. 11A.

### [Best Mode]

Hereinafter, exemplary embodiments of the present invention will be described with reference to the accompanying drawings. However, it should be understood that the present invention is not limited to particular embodiments disclosed herein and includes all modifications, equivalents and substitutions within the spirit and scope of the invention.

In addition, descriptions of known functions and constructions which may unnecessarily obscure the subject matter of the invention will be omitted.

Further, when an element is referred to as being "connected to," "supported by," "disposed on," or "stacked on" another element, it should be understood that the element may be directly connected to, supported by, disposed on, or stacked on to the other element or intervening elements may be present.

The terminology used herein is for the purpose of describing particular embodiments and is not intended to be limiting. As used herein, the singular forms "a," "an," and "the" are intended to include the plural forms as well, unless the context clearly indicates otherwise.

In addition, spatially relative terms, such as "upper," "lower," and the like are defined with reference to the drawings, and may be expressed differently when the orientation is changed. For the same reason, in the accompanying drawings, some components are exaggerated, omitted, or schematically shown, and the dimensions of each component are not necessarily indicative of actual dimensions thereof.

Although the terms "first," "second," and the like may be used herein to describe various types of elements, these elements should not be limited by these terms. These terms are used to distinguish one element from another element.

Furthermore, the terms "comprises," "comprising," "includes," and/or "including," as used in this specification, specify the presence of stated features, regions, integers, steps, operations, elements, and/or components, but do not preclude the presence or addition of one or more other features, regions, integers, steps, operations, elements, and/or components.

The present invention provides a light emitting apparatus 10 including at least two light emitting modules 100 disposed adjacent each other. Hereinafter, exemplary embodiments of the present invention will be described in more detail with reference to the accompanying drawings.

Each of the light emitting modules 100 may include a substrate 110, at least one light emitting device 120 disposed on an upper surface of the substrate 110, and a molding layer 130 covering at least part of the light emitting device 120.

The substrate 110 is a substrate, on an upper surface of which at least one light emitting device 120 is mounted, and may be selected from any substrates, such as a circuit substrate, a lead frame, a flexible substrate, a transparent substrate, and the like, so long as the substrate can support a light emitting diode.

For example, the substrate 110 may include a printed circuit board (PCB). The PCB may be, for example, an FR4 PCB that exhibits good properties in terms of high strength, flame retardancy, chemical resistance, and the like. Alternatively, the PCB may be a metal printed circuit board (metal PCB) with good heat dissipation performance and good thermal conductivity. More specifically, the PCB may be a PCB including Cu, Zn, Au, Ni, Al, Mg, Cd, Be, W, Mo, Si, or Fe, or an alloy of at least one of these elements as a base metal. However, it should be understood that the present invention is not limited thereto and various PCBs may be used depending on product characteristics.

The substrate 110 may be formed on the upper surface thereof with a pad for mounting at least one light emitting device 120 and on a lower surface thereof with a pad to be mounted on another substrate (not shown, for example, a display substrate).

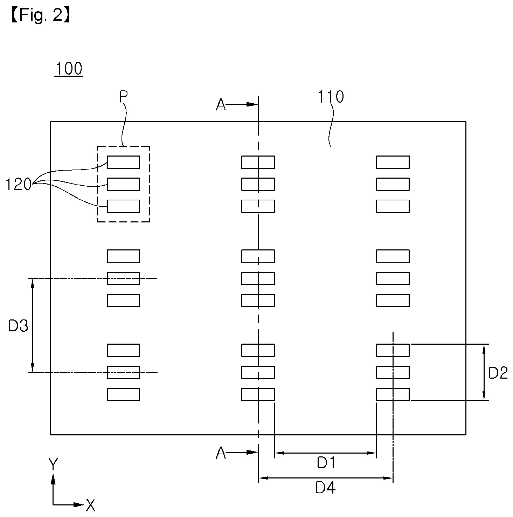

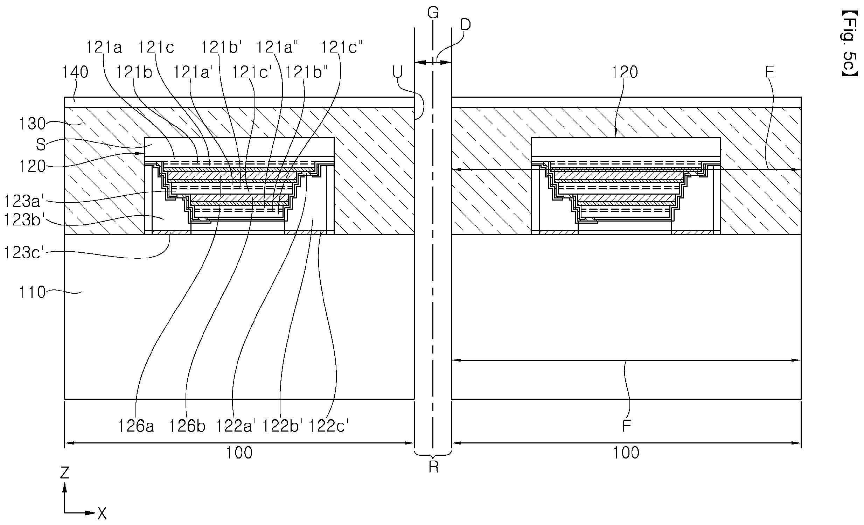

A plurality of light emitting devices 120 may be arranged in various patterns on the upper surface of the substrate 110. For example, referring to FIG. 2, three light emitting devices 120 emitting red (R), green (G) and blue (B) light, respectively, may be linearly arranged in one direction to form one pixel P. Alternatively, referring to FIG. 5C, RGB light emitting diodes may be vertically stacked in a single light emitting device 120 to form one pixel P.

As shown in FIG. 2, when the three light emitting devices 120 arranged in a horizontal direction constitute one pixel P and the arrangement direction of the three light emitting devices 120 constituting the pixel P is referred to as a first direction (Y-axis direction in the drawings), a pitch D3 (distance between the centers of the light emitting devices 10) between the light emitting devices 10 in the first direction may be set in various ways depending on design.

Further, a minimum distance D1 between adjacent pixels P in a second direction (X-axis direction in the drawings) perpendicular to the first direction may be greater than a length D2 of a reference pixel P in the first direction.

Further, the pitch D3 or D4 between adjacent pixels P in the first or second direction may be 2 mm or less and may be set according to various specifications, for example, 1.5 mm, 1.25 mm, 0.935 mm, 0.625 mm, 0.48 mm, and the like.

Although FIG. 2 shows an example in which three light emitting devices 120 are linearly arranged to constitute one pixel P, it should be understood that the present invention is not limited thereto and the light emitting devices 120 may be non-lineally arranged in a plane.

The substrate 110 may have a monolayer or multilayer structure and may be formed to various thicknesses, as needed.

For example, for the multilayer structure, the substrate 110 may include a first metal layer 112, a main insulating layer 114 under the first metal layer 112, and a second metal layer 116 under the main insulating layer 114.

The first metal layer 112 may include a plurality of metal layers M2 to M5 spaced apart from one another in the vertical direction and an insulating material. The metal layers M2 to M5 are interconnect layers electrically connected to the light emitting devices 120 and may have various configurations.

Although the number of metal layers M2 to M5 may be set in various ways, it is desirable that the number of metal layers M2 to M5 be greater than the number of light emitting devices 120 constituting one pixel P.

The first metal layer 112 may be formed on an upper surface thereof with an electrode layer M1 directly connected to the light emitting device 120. The electrode layer M1 may protrude to a thickness t2 from the upper surface of the first metal layer 112.

Here, the thickness t2 of the electrode layer M1 may be in the range of 0.03 to 0.15 times, more preferably 0.03 to 0.1 times, a thickness t1 of a molding layer 130 described below, which is disposed on the upper surface of the first metal layer 112, as described below. This structure allows heat of the electrode layer M1 to be more efficiently dissipated through the molding layer 130 described below. If the thickness of the electrode layer M1 is greater than the above thickness range, a step between the electrode layer M1 and the upper surface of the first metal layer 112 becomes larger, whereby the molding layer 130 described below can be unevenly formed on the upper surface of the first metal layer 112.

For example, the electrode layer M1 may have a thickness t2 of 7 micrometers to 12 micrometers.

The thickness of the first metal layer 112 may be less than thicknesses of the main insulating layer 114 and the second metal layer 116, and may be less than or equal to 0.2 times, preferably less than or equal to 0.18 times, the thickness of the entire substrate 110.

The main insulating layer 114 is a main body of the substrate 110 disposed under the first metal layer 112 and may have various configurations.

The main insulating layer 114 may be formed to a greater thickness than the first and second metal layers 112, 116. The main insulating layer 114 may be formed as a core layer in which no metal layer is formed, and may be formed with via-holes for electrical connection between the first and second metal layers 112, 116.

The second metal layer 116 is a layer disposed under the main insulating layer 114 and may include a plurality of metal layers M6 to M10 spaced apart from one another in the vertical direction and an insulating material. The metal layers M6 to M10 are interconnect layers electrically connected to the light emitting devices 120 and may have various configurations.

Although the number of metal layers M6 to M10 may be set in various ways, it is desirable that the number of metal layers M6 to M10 be greater than the number of light emitting devices 120 constituting one pixel P.

Among the metal layers M6 to M10, the lowermost metal layer M10 may have the smallest thickness.

In addition, the second metal layer 116 may be provided on a lower surface thereof with a driver, a connector, and the like to drive/control the light emitting devices 120.

The second metal layer 116 may have a thickness less than the thickness of the main insulating layer 114 and greater than the thickness of the first metal layer 112. In addition, the sum of the thicknesses of the first metal layer 112 and the second metal layer 116 may have a value less than the thickness of the main insulating layer 114.

The light emitting devices 120 are light emitting diodes disposed on the upper surface of the substrate 110 and may have various configurations.

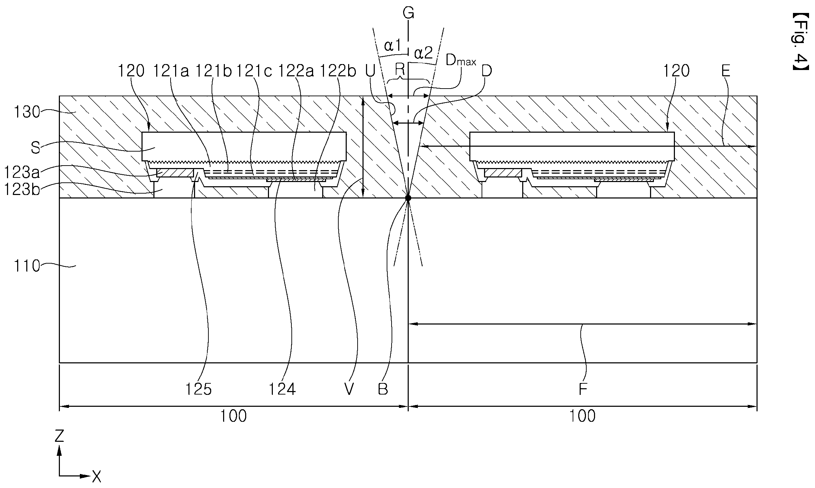

For example, each of the light emitting devices 120 may be a light emitting diode including semiconductor layers formed on a growth substrate S, as shown in FIG. 4.

The growth substrate S is selected from any substrates allowing growth of nitride semiconductor layers thereon and may include, for example, a heterogeneous substrate, such as a sapphire substrate, a gallium arsenide substrate, a silicon substrate, a silicon carbide substrate, and a spinel substrate, or a homogeneous substrate, such as a gallium nitride substrate, an aluminum nitride substrate, and the like. The growth substrate S may be removed after growth of the semiconductor layers.

The light emitting device 120 may include a first conductivity type semiconductor layer 121a, an active layer 121b, and a second conductivity type semiconductor layer 121c.

The first conductivity type semiconductor layer 121a may be a semiconductor layer grown on one surface of the growth substrate S and a buffer layer (not shown) may be further formed between the first conductivity type semiconductor layer 121a and the growth substrate S.

The first conductivity type semiconductor layer 121a may include a phosphide or nitride semiconductor, such as (Al, Ga, In)P or (Al, Ga, In)N, and may be grown on the growth substrate S by a method, such as MOCVD, MBE, HVPE, or the like. Furthermore, the first conductivity type semiconductor layer 121a may be doped with at least one n-type dopant, such as Si, C, Ge, Sn, Te, Pb, or the like, without being limited thereto. Alternatively, the first conductivity type semiconductor layer 121a may be doped with an opposite conductivity type dopant including a p-type dopant.

Furthermore, the first conductivity type semiconductor layer 121a may be composed of a single layer or multiple layers.

Furthermore, the first conductivity type semiconductor layer 122, 132, and 142 may further include a contact layer, a modulation doping layer, an electron injection layer, etc.

The active layer 121b is a light emitting layer formed on the first conductivity type semiconductor layer 122, 132, and 142. The active layer 121b may include a phosphide or nitride semiconductor, such as (Al, Ga, In)P or (Al, Ga, In)N, and may be grown on the first conductivity type semiconductor layer 121a by a technique, such as MOCVD, MBE, or HVPE.

Further, the active layer 121b may include a quantum well structure (QW) including at least two barrier layers and at least one well layer, or may include a multi-quantum well structure (MQW) including a plurality of barrier layers and a plurality of well layers.

The wavelength of light emitted from the active layer 121b may be adjusted by controlling a composition ratio of materials constituting the well layer. Here, the well layers 124b, 134b, 144b may commonly include the same element and may include In.

The second conductivity type semiconductor layer 121c may be a semiconductor layer formed on the active layer 121b.

The second conductivity type semiconductor layer 121c may include a phosphide or nitride semiconductor, such as (Al, Ga, In)P or (Al, Ga, In)N, and may be grown by a technique, such as MOCVD, MBE, or HVPE. The second conductivity type semiconductor layer 121c may be doped with a conductivity type dopant opposite to the conductivity type of the first conductivity type semiconductor layer 121a. For example, the second conductivity type semiconductor layer 121c may be doped with a p-type dopant, such as Mg.

The second conductivity type semiconductor layer 121c may be composed of a single layer having a composition, such as p-GaN, and may further include an AlGaN layer therein, without being limited thereto.

In addition, the second conductivity type semiconductor layer 121c may further include an electron-blocking layer having a high bandgap between the second conductivity type semiconductor layer 121c and the active layer 121b. The electron-blocking layer is placed on the active layer 121b and may prevent electrons from overflowing from the active layer 121b in an upward direction thereof.

Further, the light emitting device 120 may be a light emitting diode chip including a lower contact layer 124, which includes a transparent conductive material transmitting light therethrough, an insulating layer 125, a P-electrode pad 122a, and an N-electrode pad 123a.

The N and P-electrode pads 122a, 123b may be electrically connected to the substrate 110 through connection electrodes 122b, 123b. However, it should be understood that embodiments of the present invention are not limited thereto and the N and P-electrode pads 122a, 123a may be directly soldered to the substrate 110 without the connection electrodes 122b, 123b.

In another embodiment, the light emitting device 120 may be a stacked semiconductor layer with a plurality of light emitting diodes stacked one above another, as shown in FIG. 5C.

The stacked semiconductor layer may include a first light emitting stack, a second light emitting stack, and a third light emitting stack sequentially stacked one above another. The first light emitting stack may be stacked on the second light emitting stack and the third light-emitting stack may be stacked on the second light-emitting stack.

Each of the first to third light emitting stacks includes a first conductivity type semiconductor layer 121a; 121a'; 121a", an active layer 121b; 121b'; 121b", and a second conductivity type semiconductor layer 121c; 121c'; 121c".

The stacked semiconductor layer may further include adhesive layers 126a, 126b that attach the first to third light emitting stacks to one another, lower contact layers 124a, 124b, 124c, an insulating layer 150, and P and N-electrode pads 122a', 123a'. In addition, the stacked semiconductor layer may be electrically connected to the substrate 110 through connection electrodes 122b', 122c', 123b', 123c' connected to the P and N-electrode pads 122a', 123a', respectively.

The first to third light emitting stacks may be a light emitting stack emitting red light, a light emitting stack emitting green light, and a light emitting stack emitting blue light, respectively. Thus, the stacked light emitting device 120 including the first to third light emitting stacks may display RGB trichromatic colors as a pixel.

It will be apparent that the light emitting device 120 described with reference to FIG. 4 and FIG. 5C may be implemented in various structures and may be modified into a flip-chip type, a vertical type, a horizontal type, and the like. In addition, the growth substrate S may be omitted depending on the shape of the light emitting device 120.

Further, peak wavelengths of light emitted from the light emitting devices 120 disposed on the upper surface of the substrate 110 may be the same or different from each other.

By way of example, one of the three light emitting devices 120 constituting one pixel P may be a diode that emits blue light B, that is, a blue light emitting diode having a peak wavelength within the blue wavelength band. The blue light emitting diode may have a difference of 2 nm and 15 nm between the peak wavelength and a dominant wavelength thereof. Specifically, the blue light emitting diode may have a peak wavelength between 430 nm and 475 nm and a dominant wavelength between 460 nm and 480 nm. The peak wavelength of the blue light emitting diode may be shorter than the dominant wavelength thereof.

Among the three light emitting devices 120 constituting one pixel P, another light emitting diode is a diode that emits green light G, that is, a green light emitting diode having a peak wavelength within the green wavelength band. The green light emitting diode may have a difference of 5 nm and 20 nm between the peak wavelength and a dominant wavelength thereof. Specifically, the green light emitting diode may have a peak wavelength between 510 nm and 540 nm and a dominant wavelength between 525 nm and 545 nm. The peak wavelength of the green light emitting diode may be shorter than the dominant wavelength thereof.

Among the three light emitting devices 120 constituting one pixel P, a third light emitting device 120 is a diode that emits red light R, that is, a red light emitting diode having a peak wavelength within the red wavelength band. The red light emitting diode may have a difference of 5 nm and 30 nm between the peak wavelength and a dominant wavelength thereof. Specifically, the red light emitting diode may have a peak wavelength between 620 nm and 640 nm and a dominant wavelength between 600 nm and 630 nm. The peak wavelength of the red light emitting diode may be longer than the dominant wavelength thereof.

The molding layer 130 is a layer covering at least part of the light emitting device 120 and may have various configurations.

The molding layer 130 may cover both upper and side surfaces of the light emitting device 120, or may expose at least part of the upper surface of the light emitting device 120.

The molding layer 130 may be formed of, for example, acrylate, silicone, epoxy, and the like, without being limited thereto.

For example, the molding layer 130 may be formed by applying a sheet-type molding material, liquefying the molding material through high temperature treatment, and pressing the molding material towards the light emitting device 120. Alternatively, the molding layer 130 may be formed by curing a resin through UV treatment.

The sheet-type molding material may be a molding material in a semi-cured (uncured) state of a thermosetting resin or a UV-curable resin, in an intermediate stage state of curing reaction, or in a previous stage state of complete curing.

The thermosetting resin may include polymers that do not allow crosslinking reaction by heat and may become fluid or soft through increase in kinetic energy of the polymers upon application of heat thereto. Accordingly, a mold may be formed to fill the periphery of the light emitting device 120 with the molding material by pressing the molding material towards the light emitting device 120 at high temperature after application of the molding material to the light emitting device 120.

Furthermore, the molding layer 130 may be a light transmissive layer formed of a material through which light can pass. The molding layer 130 may have a light transmittance of 50% or more, preferably 70% or more. Here, the molding layer 130 may have a light blocking rate of 40% or less.

In another embodiment, the molding layer 130 may further include a light reflective material or a light absorbing material. Here, the molding layer 130 may be an opaque layer and may include a black pigment to adjust contrast of a display.

In a further embodiment, the molding layer 130 may perform both a light blocking function and a light reflecting function. For example, the molding layer 130 may be formed of a carbon black-containing molding material or a molding material combining black and white.

In yet another embodiment, the molding layer 130 may have a light absorbing function in addition to the light reflecting function. For example, the molding layer 130 may be formed of a white molding material or a molding material combining white and black. Accordingly, the molding layer 130 can adjust contrast of light emitted therethrough and can improve brightness of a display.

The molding layer 130 may have any thickness t1 in the range of 0.5 to 1.5 times the thickness of the first metal layer 112. Alternatively, the thickness t1 of the molding layer 130 may be in the range of 0.05 to 0.15 times the thickness of the substrate 110. By way of example, the molding layer 130 may be formed to a thickness t1 of 100 micrometers to 400 micrometers, more preferably 100 micrometers to 250 micrometers.

Although the molding layer 130 is illustrated as a single layer in the drawings, it should be understood that embodiments of the present invention are not limited thereto. Alternatively, the molding layer 130 may be formed by stacking a plurality of layers, each of which may perform a light control function, such as light reflection, light absorption, light blocking, light diffusion, and the like.

The light emitting module 100 may further include a light control layer 140 disposed on the molding layer 130.

At least one of the index of refraction, melting point, or light transmittance of the light control layer 140 may be different from the index of refraction, melting point, and light transmittance of the molding layer 130.

The light control layer 140 is a layer that controls light emitted from an upper side of the molding layer 130 and may have various configurations. Although not shown in the drawings, a bonding layer may be further disposed between the molding layer 130 and the light control layer 140 to attach the light control layer 140 thereto.

By way of example, the light control layer 140 may be an anti-glare layer that can prevent eye glare.

The light control layer 140 may be a film layer formed through matte treatment. For example, the light control layer 140 may be a matte film layer attached to an upper surface of the molding layer 130 and subjected to surface treatment.

Alternatively, the light control layer 140 may be formed by, for example, attaching an anti-glare (AG) film or coating with an anti-glare (AG) coating.

The light control layer 140 may have a much smaller thickness t3 than the thickness t1 of the molding layer 130. For example, the thickness t3 of the light control layer 140 may be in the range of 20 micrometers to 80 micrometers, more preferably 30 micrometers to 35 micrometers. However, it should be understood that embodiments of the present invention are not limited thereto. The light control layer 140 may have various thicknesses depending on the thickness of the film attached to the upper surface of the molding layer 130 and may be formed by selectively attaching films with various thicknesses thereto.

By way of example, the light control layer 140 may have a thickness t3 of in the range of 0.1 to 0.3 times the thickness T1 of the molding layer 130 so as to be stretchable.

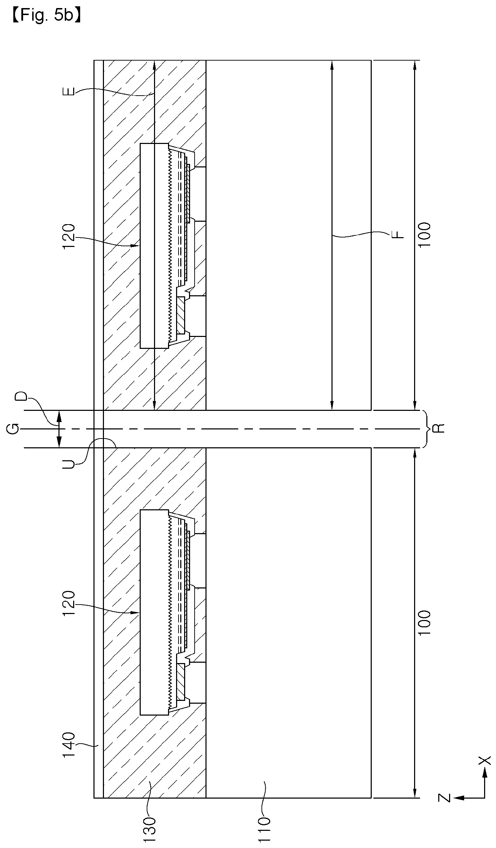

The light control layer 140 may be provided to each of the light emitting modules 100 constituting the light emitting apparatus 10, or may be integrally formed with an upper surface of the light emitting apparatus 10 after the light emitting modules 100 are disposed adjacent each other, as shown in FIG. 5B, FIG. 6B, FIG. 7B, FIG. 8C, FIG. 9B, and FIG. 10B.

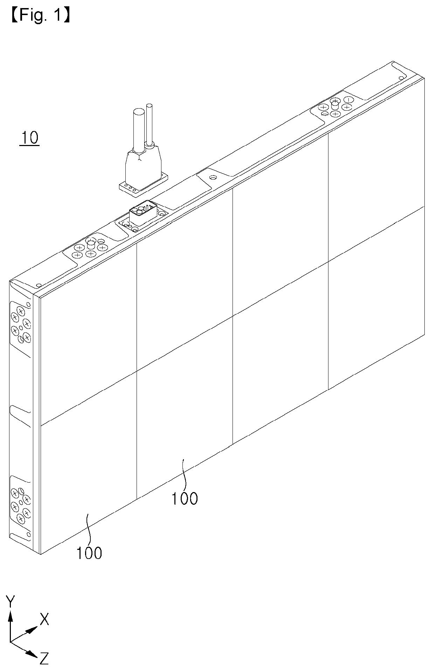

As shown in FIG. 1, the aforementioned light emitting module 100 is provided in plural and may be disposed adjacent to other light emitting modules 100 to form the light emitting apparatus 10 having various sizes, and the light emitting apparatus 10 may constitute a display apparatus.

Although FIG. 1 shows the light emitting apparatus 10 constituting the display apparatus and including eight light emitting modules 100 disposed adjacent each other in a plane, more light emitting modules 100 may be provided to the light emitting apparatus 10 depending on the size of the display apparatus and may be arranged in various patterns in a plane rather than being limited to a matrix form.

Since the light emitting modules 100 are placed adjacent each other to form the display apparatus, side surfaces of the light emitting modules 100 require suitable machining.

Next, referring to FIG. 4 to FIG. 11C, various embodiments that can prevent bright lines or dark lines from occurring at a boundary between adjacent light emitting modules 100 will be described in detail.

First, the side surfaces of the light emitting modules 100 according to the embodiment of the invention may be machined by a separate machining tool. For example, a rotating machining tool may perform various machining processes, such as roughing, grinding, and the like, on the side surface of the light emitting module 100 while moving along the periphery of the side surface of the light emitting module 100. For example, a CNC milling machine can cut/machine the light emitting module 100 while moving a machining tool that rotates at high speed, with a cutting object secured thereto. A method of cutting/machining the side surface of the light emitting module 100 is not limited to any particular method.

One side surface of the light emitting module 100 may have a vertical plane in at least some region thereof.

In addition, at least some region of the one side surface of the light emitting module 100 may form an inclined plane U.

Although not shown in the drawings, the one side surface of the light emitting module 100 may also have a stepped plane having a horizontal depth.

The one side surface of the light emitting module 100 may include a combination of a vertical plane and an inclined plane U, a combination of a vertical plane and a stepped plane, a combination of an inclined plane U and a stepped plane, or a combination of a vertical plane/inclined plane U/stepped plane.

Here, at least one side surface of each of two adjacent light emitting modules 100 may be spaced apart from an opposite side surface of the other light emitting module 100 to form a separation zone R therebetween in at least some regions thereof. In other regions excluding the separation zone R, the side surfaces of the two adjacent light emitting modules 100 may adjoin each other.

The separation zone R is a region forming an empty space in which the opposite side surfaces of the two adjacent light emitting modules 100 are spaced apart from each other without adjoining each other, and may be formed at an upper portion of the light emitting module 100, at a central portion thereof, at a lower portion thereof, or throughout the upper and lower portions of the light emitting module 100.

The empty space formed in the separation zone R may be provided with a material (A) having a lower index of refraction than adjacent materials. More specifically, the separation zone R may be provided with a material A having a lower index of refraction than the light control layer 140, the molding layer 130 or the substrate 110 disposed adjacent thereto. Accordingly, even if light enters the separation zone R, the light may be refracted by the material A having a low index of refraction and less emitted outside. In this case, a difference in index of refraction between the material A and the molding layer 130 may be 0.2 or more.

The material A may have a thermal conductivity of less than 0.05 W/mK. Thus, even if plural light emitting modules 100 are disposed adjacent each other and generate heat, the heat can be prevented from being transferred to the adjacent light emitting modules 100 and degrading performance of the adjacent light emitting modules 100.

The material A may be air and may have a thermal conductivity of 0.024 W/mK.

The inclined plane U may be formed on the side surface of each of the light emitting modules 100 in the separation zone R. The vertical plane may be formed on the side surface of each of the light emitting modules 100 in the separation zone (R).

In the separation zone R, the inclined plane U may be formed in some region of the side surface of the light emitting module 100 and the vertical plane may be formed in other regions thereof.

The inclined plane U may be a flat surface or a curved surface. Alternatively, the inclined plane U may be a combination of a flat surface and a curved surface. The curved surface constituting the inclined plane U may be an outwardly projecting convex surface or an inwardly depressed concave surface.

The inclined plane U may be formed with at least one inclination deflection point K at which the inclination of the inclined plane U is changed. When the inclined plane U is formed with a curved surface, it is obvious that the curvature of the curved surface may also be variable depending on the location thereof.

The maximum separation distance Dmax between the side surfaces of the adjacent light emitting modules 100 in the separation zone R may be less than the maximum width of at least one light emitting device 120. Alternatively, the maximum separation distance Dmax between the side surfaces of the adjacent light emitting modules 100 in the separation zone R may be less than the thickness t1 of the molding layer 130.

Alternatively, the maximum separation distance Dmax between the side surfaces of the adjacent light emitting modules 100 in the separation zone R may be less than the thickness of the first metal layer 112. Alternatively, the maximum separation distance Dmax between the side surfaces of the adjacent light emitting modules 100 in the separation zone R may be less than the thickness of the second metal layer 116. Alternatively, the maximum separation distance Dmax between the side surfaces of the adjacent light emitting modules 100 in the separation zone R may be less than the thickness of the main insulating layer 114.

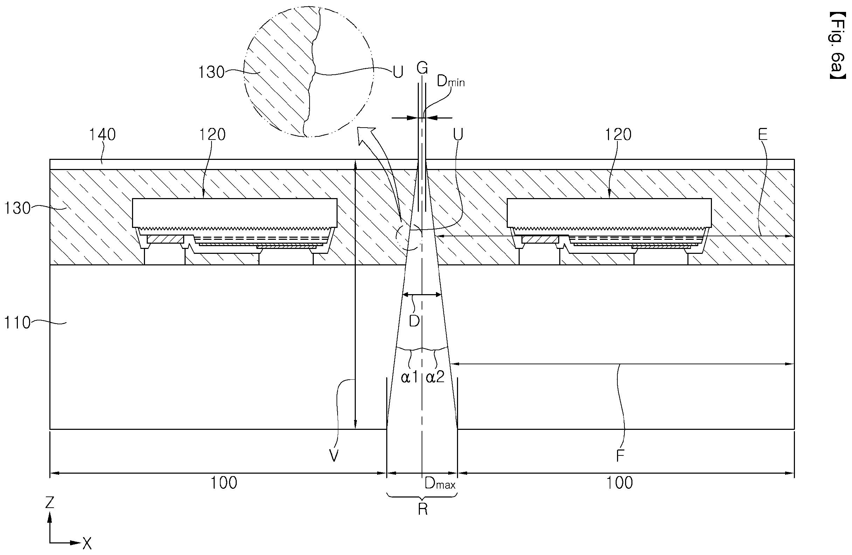

The inclined plane U may face upwards or downwards. In addition, referring to FIG. 6A, the inclined plane U may have a roughness and may also be formed with an uneven structure.

On the other hand, the separation zone R may be formed singularly or in plural in some section on the side surface of the light emitting module 100 or may extend from the uppermost end to the lowest end of the side surface of the light emitting module 100. When the separation zone(R) extends from the uppermost end to the lowermost end of the side surface of the light emitting module 100, the opposite side surfaces of the adjacent light emitting module 100 may be spaced apart from each other without any adjoining regions.

In the separation zone R, an empty space may be formed between the side surfaces of the adjacent light emitting modules 100 and the separation distance D between the opposite side surfaces thereof may have a value in the range of 1 micrometer to 100 micrometers. The separation distance D may vary depending on a pitch of pixels of the light emitting module 100 and the thickness of the light emitting module 100, particularly the thickness of the molding layer 130.

The separation distance D in the separation zone R may have a constant value from an upper end to a lower end of the light emitting module 100 or may increase or decrease in at least some region thereof.

The separation distance D may be determined based on horizontal widths E, F of the light emitting module 100 and each of the light emitting modules 100 may include a variable width zone V in which the horizontal widths E, F gradually vary from top to bottom in at least some region thereof.

For example, the variable width zone V may be formed in the molding layer 130 such that the horizontal width E of the molding layer 130 may increase or decrease in the corresponding zone. Similarly, the variable width zone V may be formed in the substrate 110 such that the horizontal width F of the substrate 110 may increase or decrease in the corresponding zone. The variable width zone V may be provided to both the molding layer 130 and the substrate side 110.

The maximum width in the variable width zone V may be less than the maximum width of at least one light emitting device 120. Alternatively, the maximum width in the variable width zone V may be less than the thickness t1 of the molding layer 130.

Alternatively, the maximum width in the variable width zone V may be less than the thickness of the first metal layer 112. Alternatively, the maximum width in the variable width zone V may be less than the thickness of the second metal layer 116. Alternatively, the maximum width in the variable width zone V may be less than the thickness of the main insulating layer 114.

Referring to the following drawings, the shape of the boundary between the light emitting modules 100 of the light emitting apparatus 10 according to the exemplary embodiments will be described in detail. It should be understood that FIG. 4 to FIG. 11C illustrate various embodiments and the present invention is not limited thereto.

First, referring to FIG. 4, two adjacent light emitting modules 100 are disposed side by side in a lateral direction and opposite side surfaces of the two light emitting modules 100 may adjoin each other in some regions while defining the separation zone R in other regions, in which the opposite side surfaces of the light emitting modules 100 are separated a preset value D from each other. In FIG. 4, the separation zone R is formed in the molding layer 130 of the light emitting module 100 and the side surfaces of the two light emitting modules 100 may adjoin each other in the remaining region of the substrate 110. In the embodiment shown in FIG. 4, the separation zone R may coincide with the variable width zone V of the light emitting module 100.

The inclined planes U are formed in the separation zone (R). Here, although the inclined planes U are shown as flat surfaces, it should be understood that embodiments of the present invention are not limited thereto.

Each of the inclined planes U formed on the side surfaces of the adjacent light emitting modules 100 may converge on a single convergence point B. The convergence point B may constitute a boundary at which the separation zone R starts. Although the convergence point B is shown as being placed at an interface between the molding layer 130 and the substrate 110 in FIG. 4, it should be understood that embodiments of the present invention are not limited thereto and the convergence point B may be placed in the molding layer 130 or in the substrate 110.

In the embodiment shown in FIG. 4, the inclined planes U in the separation zone R are formed to face upwards and the separation distance D between the adjacent light emitting modules 100 may gradually increase from a lower end of the separation zone R to an upper end thereof. Here, the separation distance D between the adjacent light emitting modules 100 may have the maximum value Dmax at the upper end of the separation zone R. Accordingly, the horizontal width E of the molding layer 130 having the separation zone R formed therein has the maximum value at a lower end of the molding layer 130 and may gradually decrease towards an upper end thereof.

The separation distance D has the maximum value Dmax at the uppermost end of the light emitting module 100. The maximum value Dmax may be less than or equal to 100 micrometers and may be in the range of, for example, 10 micrometers to 40 micrometers. The maximum separation distance Dmax may depend on the pitch of the pixels of the light emitting module 100 and the thickness of the light emitting module 100, particularly the thickness t1 of the molding layer 130.

Angles α1, α2 formed by the inclined planes U with respect to a vertical line G passing through the middle between the two adjacent light emitting modules 100 may be determined according to the separation distance D between the opposite side surfaces of the light emitting modules 100 and the thickness of the light emitting module 100 (in particular, the thickness of the molding layer 130). The angle α1 of the inclined plane U formed by one light emitting module 100 and the angle α2 of the inclined plane U formed by another light emitting module 100 may be the same or different from each other.

In FIG. 4, since the two adjacent light emitting modules 100 adjoin each other in the region of the substrate 110, the horizontal width F in the substrate 110 can be kept constant in the vertical direction.

In addition, the light emitting module 100 of FIG. 4 may be further provided on an upper surface thereof with a light control layer 140.

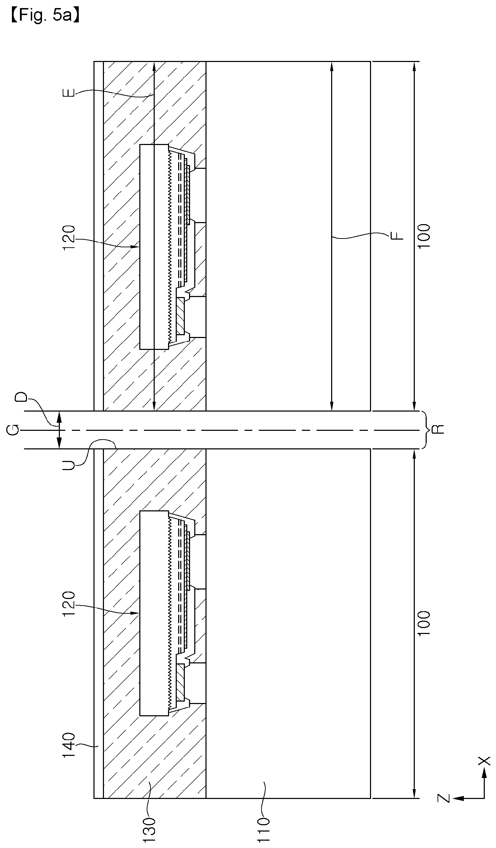

Next, FIG. 5A shows an embodiment different from the embodiment of FIG. 4, in which two adjacent light emitting modules 100 are disposed side by side in the lateral direction and opposite side surfaces of the two light emitting modules 100 may be spaced apart from each other by a predetermined constant separation distance D to form a separation zone R therebetween over the entire regions thereof. In FIG. 5A, the separation zone R may extend throughout the light control layer 140, the molding layer 130, and the substrate 110 of the light emitting module 100.

In the separation zone R, a vertical plane perpendicular to a horizontal plane may be formed on the side surface of each of the light emitting modules 100. Accordingly, the separation distance D between the light emitting modules 100 in the separation zone R may be kept constant from top to bottom of the light emitting modules 100.

The separation distance D between the light emitting modules 100 may be 100 micrometers or less and may be in the range of, for example, 10 micrometers to 40 micrometers. The separation distance D may vary depending on the pitch of pixels of the light emitting module 100 and the thickness of the light emitting module 100, particularly the thickness t1 of the molding layer 130.

In FIG. 5A, the two adjacent light emitting modules 100 may have a horizontal width E in the molding layer 130 and a horizontal width F in the substrate 110, which are constant in the vertical direction. In other words, unlike FIG. 4, in FIG. 5A, the light emitting modules 100 do not have the variable width zone V in which the horizontal widths of each of the light emitting modules 100 are changed.

On the other hand, FIG. 5B shows a modification of the embodiment shown in FIG. 5A, which is identical or similar to the embodiment shown in FIG. 5A except that the light control layer 140 is integrally formed with the upper surface of the molding layer 130 after the two light emitting modules 100 are disposed adjacent each other and thus description of the same or similar features will be omitted. In FIG. 5B, since the light control layer 140 is integrally formed with the upper surface of the molding layer 130, the separation zone R between the two adjacent light emitting modules 100 may be formed over the entire region of the molding layer 130 and the substrate 110 excluding the light control layer 140. In this case, the separation zone R between the adjacent light emitting modules 100 may be shielded from the outside by the light control layer 140.

FIG. 5C shows a modification of the embodiment shown in FIG. 5A, which is identical or similar to the embodiment shown in FIG. 5A except that the light emitting device 120 is a stacked semiconductor layer composed of light emitting stacks stacked in the vertical direction, and thus description of the same or similar features will be omitted. Although the light emitting device 120 is shown as the stacked semiconductor layer only in FIG. 5C, it should be understood that the stacked semiconductor layer may be applied as the light emitting device 120 to other embodiments, as shown in FIG. 5C.

In FIG. 5A and FIG. 5B, the light control layer 140 may be omitted.

Next, FIG. 6A shows an embodiment different from the embodiments shown in FIG. 4 to FIG. 5C, in which two adjacent light emitting modules 100 are disposed side by side in the lateral direction and opposite side surfaces of the two light emitting modules 100 may be spaced apart from each other to form a separation zone R therebetween over the entire regions thereof. In FIG. 6A, the separation zone R may extend throughout the light control layer 140, the molding layer 130, and the substrate 110 of the light emitting module 100.

The separation zone R is formed with inclined planes U. Here, although the inclined planes U are shown as flat surfaces, the inclined planes U may have a certain degree of roughness and may have various surface morphologies, such as a separate uneven surface, as shown in an enlarged view.

The inclined planes U formed on the side surfaces of the adjacent light emitting modules 100 do not meet each other in any region of the light emitting module 100. That is, a convergence point B is not formed in any region of the light emitting module 100, unlike the embodiment shown in FIG. 4.

In the embodiment of FIG. 6A, the inclined planes U in the separation zone R are formed to face downwards unlike the embodiment shown in FIG. 4 and the separation distance D between the adjacent light emitting modules 100 may gradually decrease from the lower end of the separation zone R to the upper end thereof. Here, the separation distance D between the adjacent light emitting modules 100 may have the maximum value Dmax at the lower end of the separation zone R and the minimum value Dmin at the upper end thereof.

In FIG. 6A, the separation zone R may coincide with the variable width zone V in which the horizontal widths of the light emitting module 100 are changed. Accordingly, the horizontal width E of the molding layer 130 having the separation zone R formed therein may gradually increase from the lower end of the molding layer 130 to the upper end thereof and the horizontal width F of the substrate 110 may also gradually increase from a lower end of the substrate 110 to an upper end thereof.

For example, the separation distance D at the interface between the molding layer 130 and the substrate 110 may be in the range of 20 µm to 340 µm. The separation distance D in the region of the substrate 110 may be greater than the separation distance D at the interface therebetween, and the separation distance D in the region of the molding layer 130 may be less than the separation distance D at the interface therebetween.

Referring to FIG 6A, the minimum separation distance Dmin formed at the uppermost end of the light emitting module 100 may be less than or equal to 100 micrometers and may be in the range of, for example, 10 micrometers to 40 micrometers. At the uppermost end of the light emitting module 100, the separation distance Dmin may depend on the pitch of pixels of the light emitting module 100 and the thickness of the light emitting module 100, particularly the thickness t1 of the molding layer 130.

Angles α1, α2 formed by the inclined planes U with respect to the vertical line G passing through the middle between the two adjacent light emitting modules 100 may be determined according to the separation distance D between the opposite side surfaces of the light emitting modules 100 and the thickness of the light emitting module 100 (in particular, the thickness t1 of the molding layer 130). The angle α1 of the inclined plane U formed by one light emitting module 100 and the angle α2 of the inclined plane U formed by another light emitting module 100 may be the same or different from each other. An angle formed by the two inclined planes U is the sum (α1+α2) of the angles α1, α2 each formed between the inclined plane U and the vertical line G and may be in the range of 5° to 45°.

The inclined planes U of the light emitting module 100 may have a certain degree of roughness and may have various surface morphologies, such as a separate uneven surface.

The inclined planes U may include an uneven microstructure. An uneven micro-profile formed on the inclined plane U of the molding layer 130 and an uneven micro-profile formed on the inclined plane U of the substrate 110 may have different shapes.

The uneven microstructure formed on the inclined plane U of the molding layer 130 may have a different depth from the uneven microstructure formed on the inclined plane U of the substrate 110.

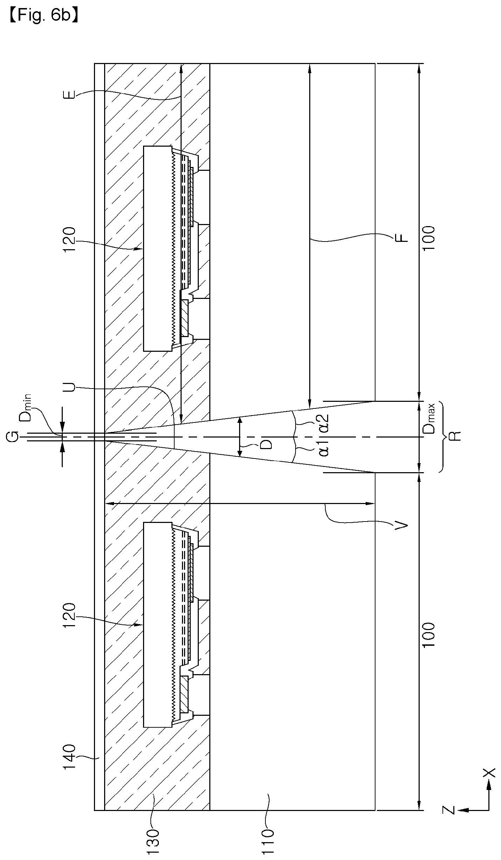

On the other hand, FIG. 6B shows a modification of the embodiment shown in FIG. 6A, which is identical or similar to the embodiment shown in FIG. 6A except that the light control layer 140 is integrally formed with the upper surface of the molding layer 130 after the two light emitting modules 100 are disposed adjacent each other, and thus description of the same or similar features will be omitted. Referring to FIG. 6B, since the light control layer 140 is integrally formed with the upper surface of the molding layer 130, the separation zone R between the two adjacent light emitting modules 100 is formed across the remaining molding layer 130 and the substrate 110 excluding the light control layer 140, and the separation zone D may have the minimum value Dmin at the uppermost end of the molding layer 130.

In FIG. 6A and FIG. 6B, the light control layer 140 may be omitted.

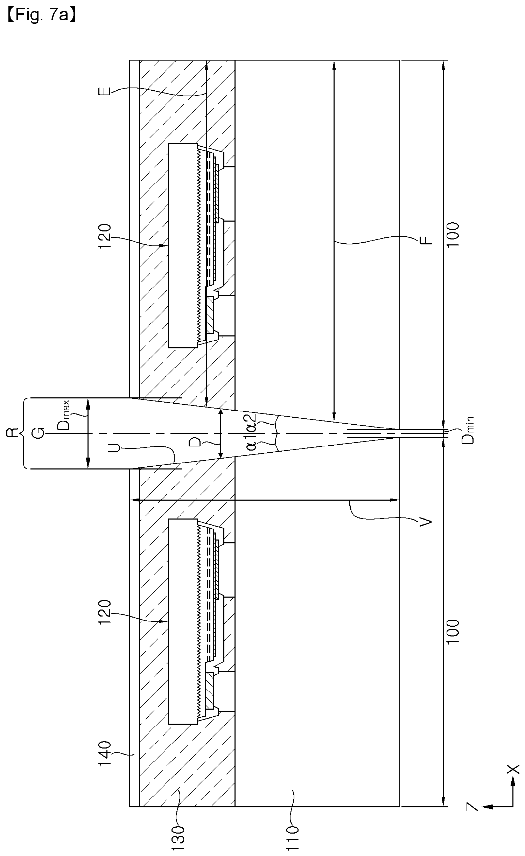

Next, FIG. 7A shows an embodiment different from the embodiments shown in FIG. 4 to FIG. 6B, in which two adjacent light emitting modules 100 are disposed side by side in the lateral direction and opposite side surfaces of the two light emitting modules 100 may be spaced apart from each other to form a separation zone R therebetween over the entire regions thereof. In FIG. 7A, the separation zone R may also extend throughout the light control layer 140, the molding layer 130, and the substrate 110 of the light emitting module 100.

The inclined planes U formed on the side surfaces of the adjacent light emitting modules 100 do not meet each other in any region of the light emitting module 100. That is, a convergence point B is not formed in any region of the light emitting module 100, unlike the embodiment shown in FIG. 4.

In the embodiment of FIG. 7A, the inclined planes U in the separation zone R are formed to face upwards, like the embodiment shown in FIG. 4, and the separation distance D between the adjacent light emitting modules 100 may gradually increase from the lower end of the separation zone R to the upper end thereof. Here, the separation distance D between the adjacent light emitting modules 100 may have the minimum value Dmin at the lower end of the separation zone R and the maximum value Dmax at the upper end thereof.

In FIG. 7A, the separation zone R may coincide with the variable width zone V in which the horizontal widths of the light emitting module 100 are changed. Accordingly, the horizontal width E of the molding layer 130 having the separation zone R formed therein may gradually decrease from the lower end thereof to the upper end thereof and the horizontal width F of the substrate 110 may also gradually decrease from the lower end thereof to the upper end thereof.

By way of example, the separation distance D at the interface between the molding layer 130 and the substrate 110 may be in the range of 20 µm to 340 µm. The separation distance D in the region of the substrate 110 may be less than the separation distance D at the interface therebetween and the separation distance D in the region of the molding layer 130 may be greater than the separation distance D at the interface therebetween.

Referring to FIG 7A, the maximum separation distance Dmax formed at the uppermost end of the light emitting module 100 may be less than or equal to 100 micrometers and may be in the range of, for example, 10 micrometers to 40 micrometers. At the uppermost end of the light emitting module 100, the separation distance Dmax may depend on the pitch of pixels of the light emitting module 100 and the thickness of the light emitting module 100, particularly the thickness t1 of the molding layer 130.

Angles α1, α2 formed by the inclined planes U with respect to the vertical line G passing through the middle between the two adjacent light emitting modules 100 may be determined according to the separation distance D between the opposite side surfaces of the light emitting modules 100 and the thicknesses of the light emitting modules 100 (in particular, the thickness t1 of the molding layer 130). The angle α1 of the inclined plane U formed by one light emitting module 100 and the angle α2 of the inclined plane U formed by another light emitting module 100 may be the same or different from each other.

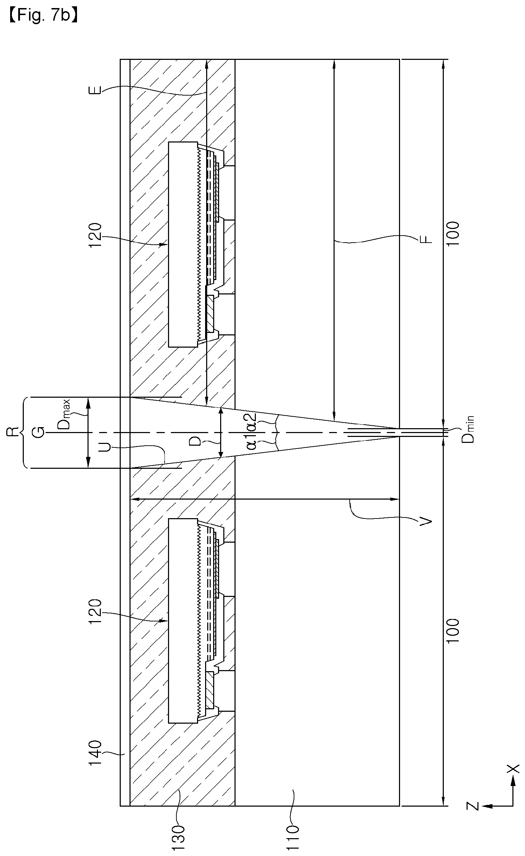

On the other hand, FIG. 7B shows a modification of the embodiment shown in FIG. 7A, which is identical or similar to the embodiment shown in FIG. 7A except that the light control layer 140 is integrally formed with the upper surface of the molding layer 130 after the two light emitting modules 100 are disposed adjacent each other, and thus description of the same or similar features will be omitted. Since the light control layer 140 is integrally formed with the upper surface of the molding layer 130, the separation zone R between the two adjacent light emitting modules 100 is formed across the remaining molding layer 130 and the substrate 110 excluding the light control layer 140, and the separation zone D may have the maximum value Dmax at the uppermost end of the molding layer 130.

In FIG. 7A and FIG. 7B, the light control layer 140 may be omitted.

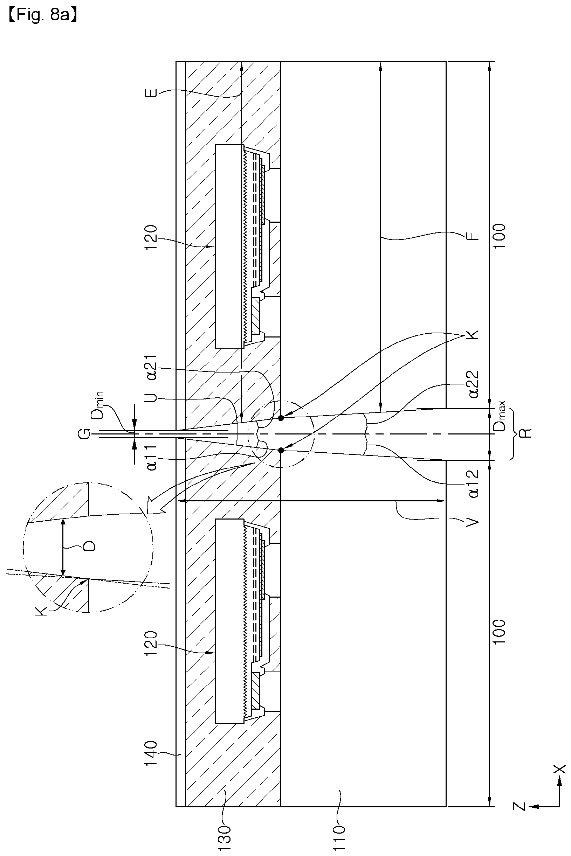

Next, FIG. 8A shows an embodiment different from the embodiments shown in FIG. 4 to FIG. 7B, in which two adjacent light emitting modules 100 are disposed side by side in the lateral direction and opposite side surfaces of the two light emitting modules 100 may be spaced apart from each other to form a separation zone R therebetween over the entire regions thereof. In FIG. 8A, the separation zone R may also extend throughout the light control layer 140, the molding layer 130, and the substrate 110 of the light emitting module 100.

FIG. 8A shows a modification of the embodiment shown in FIG. 6A, which is identical or similar to the embodiment shown in FIG. 6A except that an inclination deflection point K is formed on each inclined plane U, and thus description of the same or similar features will be omitted. Although FIG. 8A illustrates an example in which one inclination deflection point K is formed on each inclined plane U, it should be understood that embodiments of the present invention are not limited thereto and a plurality of inclination deflection points K may be formed thereon.

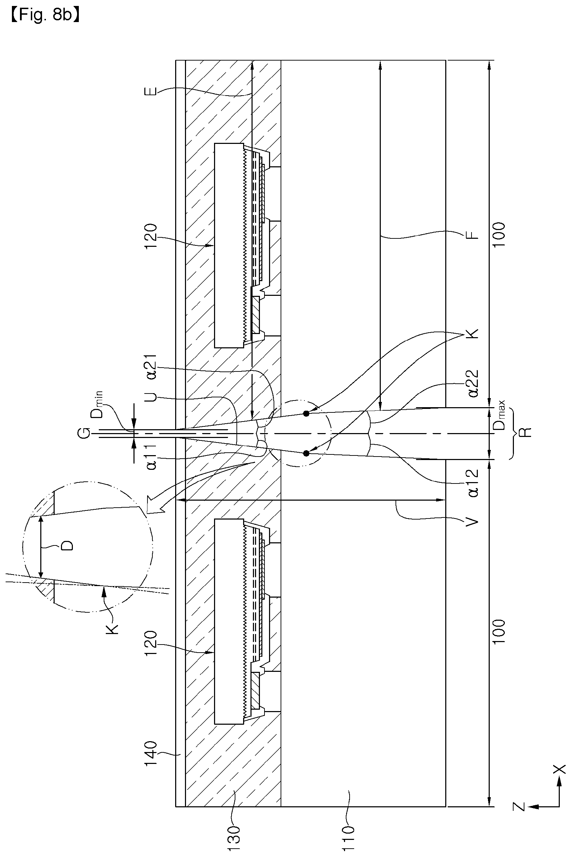

Furthermore, although FIG. 8A shows that the inclination deflection point K is formed at the interface between the molding layer 130 and the substrate 110, it should be understood that embodiments of the present invention are not limited thereto and the inclination deflection point K may also be formed in a region of the molding layer 130 or in a region of the substrate 110, as shown in FIG. 8B.

With reference to the inclination deflection point K, inclination angles α11, α21 of the inclined planes formed in the region of the molding layer 130 may be different from inclination angles α21, α22 formed in the region of the substrate 110. That is, the inclination angles α11, α21 of the inclined planes formed in the region of the molding layer 130 may be greater or less than the inclination angles α21, α22 formed in the region of the substrate 110. By defining the inclination angles α11, α21 of the inclined planes formed in the region of the molding layer 130 to be different from the inclination angles α21, α22 formed in the region of the substrate 110, an elongated surface path may be provided to the inclined plane U, thereby increasing a probability that light traveling along the surface path can be extinguished.

FIG. 8B shows a modification of the embodiment shown in FIG. 8A, which is identical or similar to the embodiment shown in FIG. 8A except that the inclination deflection point K is formed on the region of the substrate 110, and thus description of the same or similar features will be omitted.

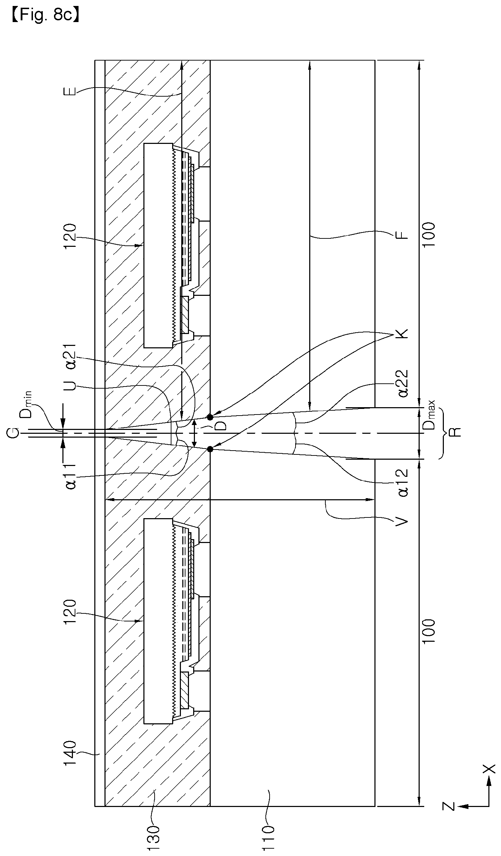

On the other hand, FIG. 8C shows a modification of the embodiment shown in FIG. 8A, which is identical or similar to the embodiment shown in FIG. 8A except that the light control layer 140 is integrally formed with the upper surface of the molding layer 130 after the two light emitting modules 100 are disposed adjacent each other, and detailed description thereof will be omitted. Since the light control layer 140 is integrally formed with the upper surface of the molding layer 130, the separation zone R between the two adjacent light emitting modules 100 is formed across the molding layer 130 and the substrate 110 excluding the light control layer 140 and the separation zone D may have the minimum value Dmin at the uppermost end of the molding layer 130.

In FIG. 8A to FIG. 8C, the light control layer 140 may be omitted.

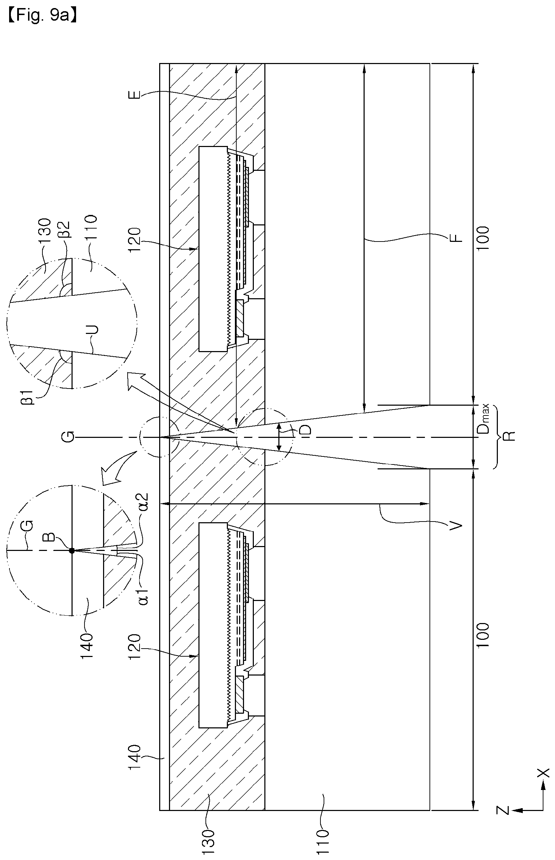

Next, FIG. 9A shows an embodiment different from the embodiments shown in FIG. 4 to FIG. 8C, in which two adjacent light emitting modules 100 are disposed side by side in the lateral direction and opposite side surfaces of the two light emitting modules 100 may be spaced apart from each other to form a separation zone R therebetween over the entire regions thereof. In FIG. 9A, the separation zone R may also extend throughout the light control layer 140, the molding layer 130, and the substrate 110 of the light emitting module 100.

FIG. 9A is identical or similar to FIG. 6A except that the light emitting modules 100 are formed at the uppermost ends thereof with a convergence point B at which the inclined planes U of the opposite side surfaces of the light emitting modules 100 converge and adjoin each other, and thus description of the same or similar features will be omitted.

In FIG. 9A, the adjacent light emitting modules 100 adjoin each other at the convergence point B and may be in a close contact state at the boundary therebetween in top plan view.

In FIG. 9A, since the uppermost ends of the adjacent light emitting modules 100 adjoin each other, the adjacent light emitting modules 100 may adjoin side-by-side in top plan view.

Since each of the inclined planes U faces downwards and forms an angle α1, α2 with respect to the vertical line G passing through the middle between the two adjacent light emitting modules 100, upper angles β1, β2 between the inclined planes U and the interface between the molding layer 130 and the substrate 110 are formed as obtuse angles greater than 90° and may be the same or different from each other depending on the inclination of the inclined planes U. Conversely, when each of the inclined planes U faces upwards, the upper angles β1, β2 defined between the inclined planes U and the interface between the molding layer 130 and the substrate 110 may be formed as acute angles less than 90°.

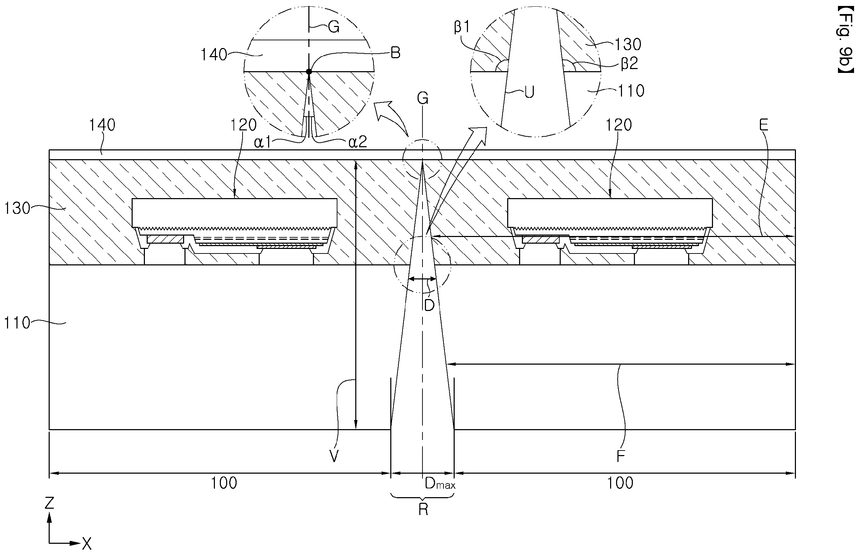

On the other hand, FIG. 9B shows a modification of the embodiment shown in FIG. 9A, which is identical or similar to the embodiment shown in FIG. 9A except that the light control layer 140 is integrally formed with the upper surface of the molding layer 130 after the two light emitting modules 100 are disposed adjacent each other, and thus description of the same or similar features will be omitted. Referring to FIG. 9B, since the light control layer 140 is integrally formed with the upper surface of the molding layer 130, the separation zone R between the two adjacent light emitting modules 100 is formed across the remaining molding layer 130 and the substrate 110 excluding the light control layer 140, and a convergence point B where the two inclined planes U meet may be formed at the uppermost end of the molding layer 130.

Although not shown in the drawings, it should be understood that the present invention may also be implemented in other embodiments in which each of the inclined planes U shown in FIG. 9A or FIG. 9B is formed with at least one inclination deflection point K, or is formed as a curved surface.

In FIG. 9A and FIG. 9B, the light control layer 140 may be omitted.

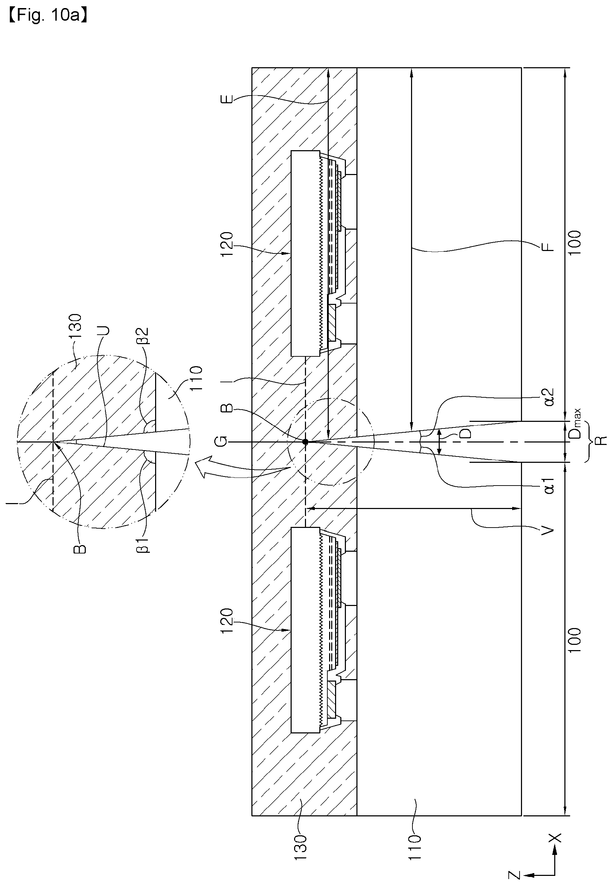

Next, FIG. 10A shows an embodiment different from the embodiments shown in FIG. 4 to FIG. 9B, in which two adjacent light emitting modules 100 are disposed side by side in the lateral direction and opposite side surfaces of the two light emitting modules 100 may be spaced apart from each other to form a separation zone R therebetween in some regions thereof.

FIG. 10A is identical or similar to FIG. 9A except the separation zone R starts from a region of the molding layer 130 of the light emitting module 100 and extends to the lower end of the light emitting module 100 and the light control layer 140 is omitted, and thus description of the same or similar features will be omitted.

Referring to FIG. 10A, the separation distance D at the interface between the molding layer 130 and the substrate 110 may be in the range of 5 micrometers to 200 micrometers. Accordingly, the separation distance D in the region of the substrate 110 may be greater than the separation distance D at the interface between the molding layer 130 and the substrate 110, and the separation distance D in the region of the molding layer 130 may be less than the separation distance D at the interface therebetween.

In FIG. 10A, the light emitting modules 100 may adjoin each other from upper portions of the light emitting modules 100 excluding the separation zone (R) to a convergence point B where the separation zone R starts. In FIG. 10A, since a contact area between the adjacent light emitting modules 100 is larger than that shown in FIG. 9A, bonding strength between the adjacent light emitting modules 100 increases, thereby enabling stable bonding therebetween.

An imaginary horizontal line l passing through the convergence point B may be placed higher than the semiconductor layer of the light emitting device 120.

The horizontal width E of the molding layer 130 is constant from the uppermost end of the molding layer 130 to the imaginary horizontal line I and may gradually decrease from the imaginary horizontal line I to the interface between the molding layer 130 and the substrate 110. Similarly, the horizontal width F of the substrate 110 may gradually decrease from the upper surface of the substrate 110 to the bottom thereof.

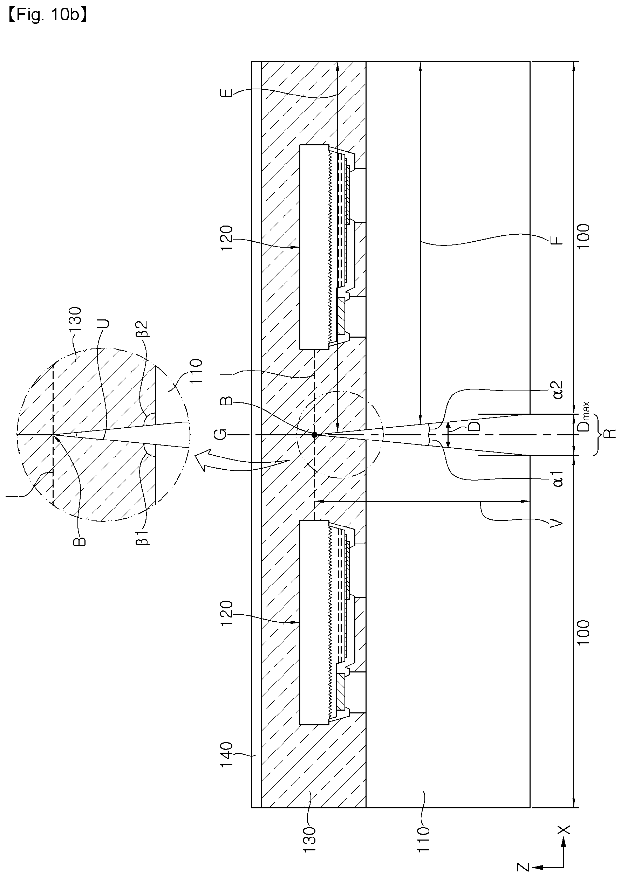

On the other hand, FIG. 10B shows a modification of the embodiment shown in FIG. 10A, which is identical or similar to the embodiment shown in FIG. 10A except that the light control layer 140 is further formed on the upper surface of the molding layer 130 and detailed description thereof will be omitted.

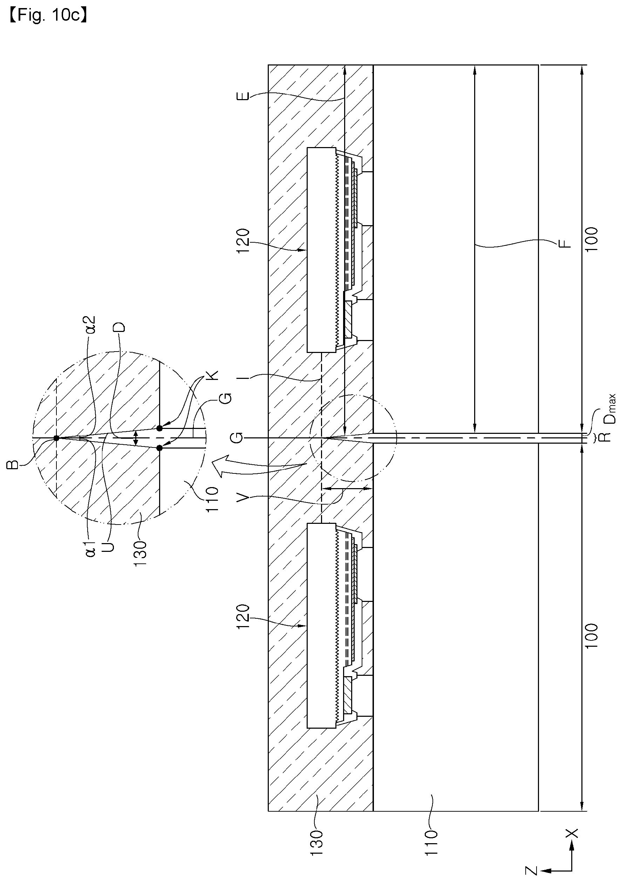

Next, FIG. 10C shows a modification of the embodiment shown in FIG. 10A, which is identical or similar to the embodiment shown in FIG. 10A except that an inclination deflection point K is formed at the interface between the molding layer 130 and the substrate 110. In FIG. 10C, a side surface of the molding layer 130 may be an inclined plane U and a side surface of the substrate 110 may be a vertical plane with respect to the inclination deflection point K. Alternatively, an inclined plane U having a different angle may also be formed on the side surface of the substrate 110. As shown in FIG. 10C, when the side surface of the substrate 110 is a vertical plane, the variable width zone V of the light emitting module 100 does not coincide with the separation zone R and may be defined as a vertical zone from the convergence point B to the inclination deflection point K.

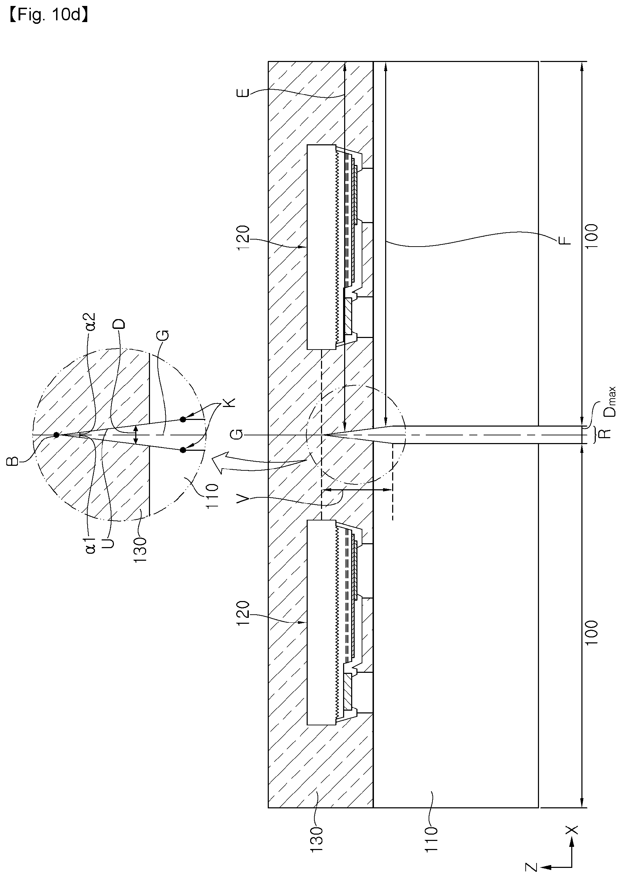

FIG. 10D is the same as or similar to FIG. 10A to FIG. 10C except that the inclination deflection point K is formed in a region of the substrate 110 rather than at the interface between the molding layer 130 and the substrate 110, and thus detailed description thereof will be omitted.

On the other hand, in FIG. 10C and FIG. 10D, it is obvious that the light control layer 140 is further formed on the upper surface of the molding layer 130.

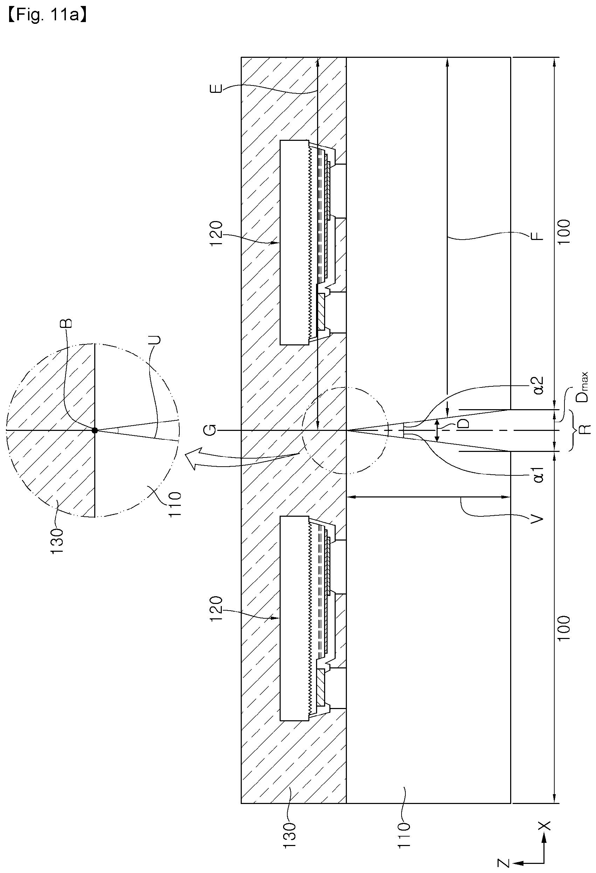

Next, FIG. 11A shows an embodiment different from the embodiments shown in FIG. 4 to FIG. 10D, in which two adjacent light emitting modules 100 are disposed side by side in the lateral direction and opposite side surfaces of the two light emitting modules 100 may be spaced apart from each other to form a separation zone R therebetween in some regions thereof. In FIG. 11A, the separation zone R may start from the interface between the molding layer 130 of the light emitting module 100 and the substrate 110 to the lowermost end thereof.

FIG. 11A may be the same as or similar to FIG. 10A to FIG. 10D except that the convergence point B of the inclined planes U formed on the side surfaces of the two adjacent light emitting modules 100 is placed at the interface between the molding layer 130 and the substrate 110. In FIG. 11A, the separation zone R may coincide with the variable width zone V, without being limited thereto.

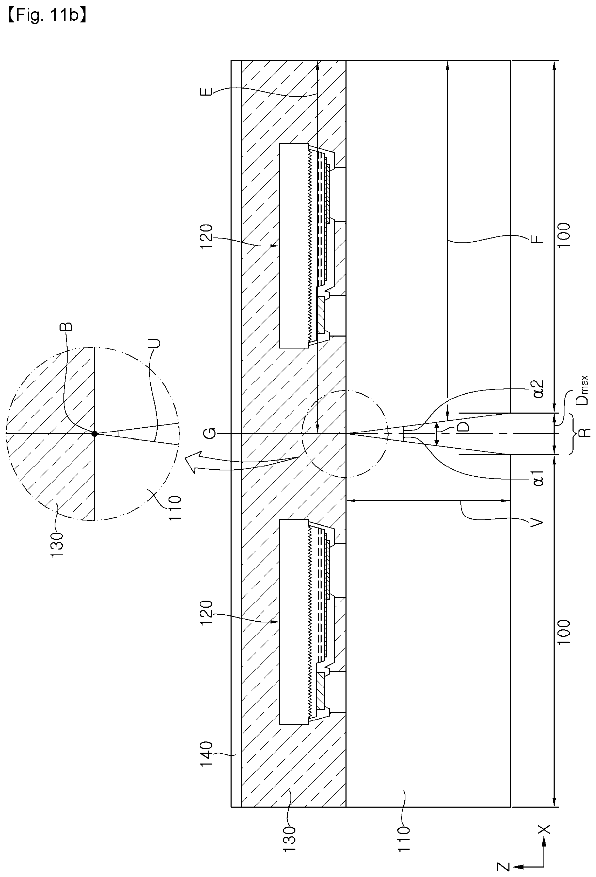

On the other hand, FIG. 11B shows a modification of the embodiment shown in FIG. 11A and may be the same as or similar to FIG. 11A except that the light emitting module 100 further include a light control layer 140.

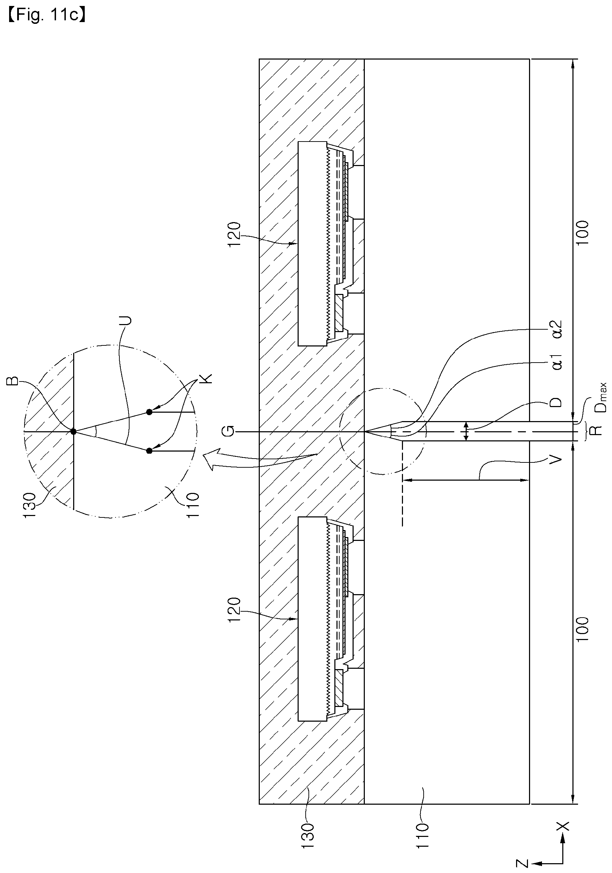

FIG. 11C shows a modification of the embodiment shown in FIG. 11B and may the same as or similar to FIG. 11B except that an inclination deflection point K is formed on each of the inclined planes U forming an empty space between the side surfaces of the adjacent light emitting modules 100 spaced apart from each other. Referring to FIG. 11C, since a vertical plane is formed under the inclination deflection point K, the separation zone R does not coincide with the variable width zone V and may be defined as a zone from the interface between the molding layer 130 and the substrate 110 to an imaginary horizontal line passing through the inclination deflection point K.

In FIG. 11A to FIG. 11C, the separation distance D between the side surfaces of the adjacent light emitting modules 100 in the separation zone R may be in the range of 5 micrometers to 400 micrometers and may be determined in various ways depending on design without being limited thereto.

It should be noted that, in all of the embodiments described above, the light emitting module 100 is not required to include the light control layer 140 and various embodiments in which the light control layer 140 is added or omitted are possible.

On the other hand, although not shown in the drawings, the thicknesses of the molding layer 130 and the substrate 110 of the adjacent light emitting modules 100 may not be completely the same and may be different from each other. Thus, when two light emitting modules 100 are disposed adjacent each other, a lower surface of one molding layer 130 may be disposed below a lower surface of the other molding layer 130. As a result, a height difference may be formed between the lower surfaces of the two molding layers 130. Here, the height difference may be managed in the range of 1 micrometer to 150 micrometers.

Alternatively, an upper surface of one molding layer 130 may be disposed below an upper surface of the other molding layer 130. As a result, a height difference may be formed between the upper surfaces of the two molding layers 130. Here the height difference may be managed in the range of 1 micrometer to 150 micrometers.

The light emitting apparatus 10 according to the above embodiments of the present invention can change a light path using the separation zone R, which is formed between the adjacent light emitting modules 100 to define an empty space at the boundary therebetween. Accordingly, the light emitting apparatus 10 can effectively solve a problem of unintentional emission of light in an upward direction. In other words, the light emitting apparatus 10 according to the embodiments of the present invention has a side shape that lowers the light path to prevent light emitted from the side surfaces of the light emitting modules 100 from being emitted upwards at the boundary therebetween, and the empty space formed between the light emitting modules 100 by the side surfaces thereof, thereby effectively blocking bright lines or dark lines due to boundaries between a plurality of light emitting modules 100 joined to one another.

Accordingly, the light emitting apparatus 10 according to the present invention can block bright lines and dark lines caused by light traveling upwards from the boundary between the adjacent light emitting modules 100, whereby a display apparatus with improved luminance uniformity can be implemented.

Although some exemplary embodiments have been described herein with reference to the accompanying drawings, it should be understood that various modifications and changes can be made by those skilled in the art or by a person having ordinary knowledge in the art without departing from the spirit and scope of the present invention, as defined by the claims and equivalents thereto.

Therefore, the scope of the present invention should be defined by the appended claims and equivalents thereto rather than by the detailed description of the invention.

## Claims

1. A light emitting apparatus (10) comprising at least two light emitting modules (100) disposed adjacent each other,
wherein each of the light emitting modules (100) comprises a substrate (110), at least one light emitting device (120) disposed on an upper surface of the substrate (110), and a molding layer (130) covering at least part of the light emitting device (120); and
at least one side surface of one of the two adjacent light emitting modules (100) is spaced apart from an opposite side surface of the other light emitting module (100) to form a separation zone R therebetween in at least some regions thereof.

2. The light emitting apparatus (10) according to claim 1, wherein an inclined plane (U) is formed on the side surface of the light emitting module (100) in the separation zone (R).

3. The light emitting apparatus (10) according to claim 2, wherein the separation zone (R) is formed with at least one inclination deflection point (K) at which an inclination of the inclined plane (U) changes.

4. The light emitting apparatus (10) according to claim 2, wherein the inclined plane (U) faces upwards.

5. The light emitting apparatus (10) according to claim 2, wherein the inclined plane (U) faces downwards.

6. The light emitting apparatus (10) according to claim 1, wherein a vertical plane is formed on the side surface of the light emitting module (100) in the separation zone (R).

7. The light emitting apparatus (10) according to claim 1, wherein a separation zone (R) extends from an uppermost end of the side surface of the light emitting module (100) to a lowermost end thereof.

8. The light emitting apparatus (10) according to claim 7, wherein a separation distance (D) between the adjacent light emitting modules (100) has a minimum value at an uppermost end of the separation zone (R).

9. The light emitting apparatus (10) according to claim 7, wherein a separation distance (D) between the adjacent light emitting modules (100) has a maximum value at a lowermost end of the separation zone (R).

10. The light emitting apparatus (10) according to claim 1, wherein the side surfaces of the two adjacent light emitting modules (100) adjoin each other in remaining regions thereof excluding the separation zone (R).

11. The light emitting apparatus (10) according to claim 1, wherein a separation distance (D) between the adjacent light emitting modules (100) in the separation zone (R) has a value in the range of 1 micrometer to 100 micrometers.

12. The light emitting apparatus (10) according to claim 1, further comprising:
a light control layer 140 disposed on the molding layer 130.

13. A light emitting apparatus (10) comprising at least two light emitting modules (100) disposed adjacent each other,
wherein each of the light emitting module (100) comprises a substrate (110), at least one light emitting device (120) disposed on one surface of the substrate (110), and a molding layer (130) covering at least part of the light emitting device (120), and
opposite side surfaces of the adjacent light emitting modules (100) form inclined planes (U) in at least some regions thereof.

14. The light emitting apparatus (10) according to claim 13, wherein the adjacent light emitting modules (100) are spaced apart from each other on a plane.

15. The light emitting apparatus (10) according to claim 14, wherein a separation distance (D) between the opposite side surfaces of the adjacent light emitting modules (100) on the inclined planes (U) increases from top to bottom of the light emitting modules (100).

16. The light emitting apparatus (10) according to claim 13, wherein the molding layer (130) has a horizontal width (E) decreasing in at least some region thereof from top to bottom of the molding layer (130).

17. The light emitting apparatus (10) according to claim 14, wherein a separation distance (D) between the opposite side surfaces of the adjacent light emitting modules (100) has a minimum value at an uppermost end of the molding layer (130).

18. A light emitting apparatus comprising at least two light emitting modules (100) disposed adjacent each other,
wherein each of the light emitting modules (100) comprises a substrate (110), at least one light emitting device (120) disposed on one surface of the substrate (110), and a molding layer (130) covering at least part of the light emitting device (120), and is provided with a variable width zone (V) in at least some region thereof in which a horizontal width of the light emitting module (100) changes from top to bottom thereof.

19. The light emitting apparatus according to claim 18, wherein, in the variable width zone (V), the horizontal width of the light emitting module (100) decreases from top to bottom of the light emitting module (100).

20. The light emitting apparatus according to claim 18, wherein the adjacent light emitting devices (100) are spaced apart from each other.
